# EUROPEAN PATENT APPLICATION

(11) **EP 0 690 499 A2**
(43) Date of publication of application: **03.01.1996**
(21) Application number: 95304597.8
(22) Date of filing: 29.06.1995
(51) Int. Cl.: H01L 23/31, H01L 21/56

(54) **Paddleless molded plastic semiconductor chip package**

(30) Priority: 30.06.1994 US 269264
(71) Applicant: DIGITAL EQUIPMENT CORPORATION, Maynard, Massachusetts 01754-1499 (US)
(72) Inventor: Hamburgen, William Riis, Palo Alto, California 94306 (US); Dordi, Yezdi Naval, Cambridge, Massachusetts 02140 (US); Fitch, John Stuart, NEwark, California 94560 (US)
(74) Representative: Goodman, Christopher

(57) **Abstract**

A semiconductor package and method in which a semiconductor chip is mounted within an opening of a lead frame by bonding wires extending between an active front side of the chip and bonding pads of the lead frame; the lead frame/chip assembly is encased within a plastic molded body, with an inactive back surface of the semiconductor chip exposed and facing outside the package.

## Description

### Field of the Invention

The present invention relates to semiconductor devices, and, in particular, is directed to the packaging of a semiconductor chip.

### Background of the Invention

Packaging is one of the final steps in the process of manufacturing semiconductor chips. In packaging, a fabricated semiconductor chip is mounted within a protective housing. At the present moment, the art of semiconductor chip technology has evolved far more rapidly than the integrally related technology of packaging the semiconductor chips. The packaging requirements of the newer, smaller, more powerful semiconductor chips are quickly progressing beyond the capabilities of traditional packaging technology and the conventional materials and designs presently utilized are fast becoming obsolete. The packaging demands of new semiconductors require configurations to accommodate increasing numbers of electrical interconnections, space constraints due to decreasing size, reduction in costs, improved reliability, and increasing heat transfer capabilities.

The need to adequately transfer heat out of increasingly smaller semiconductor packages has spawned significant interest in the development of new packaging materials and more thermally efficient configurations. Currently, semiconductor packaging utilizes the art of attaching an external heat sink to improve the heat transfer characteristics of many chip packages which, by themselves, do not adequately transfer heat away from the semiconductor chip. However, with the increasing heat concentration of new semiconductor chips the standard addition of an external heat sink is no longer sufficiently thermally efficient.

In packaging technology, the two most significant modes of heat transfer are heat conduction and heat convection. The removal of heat through a medium or between media is based on temperature differential, i.e. heat flowing from hot to cold, until an equilibrium is reached. Both convection and conduction heat transfer modes are paramount in evaluating the heat transfer characteristics of semiconductor packages and/or attached heatsink members.

The heat dissipating characteristics of semiconductor packages are measured by a network of heat transfer pathways through which heat must flow. The heat must be conducted from the chip through various thermal pathways to reach an outer surface of the package exposed to a cooling fluid, such as air. The fluid then convects away the heat.

Every packaging material has its own unique thermal characteristics. One of these characteristics is known as thermal conductivity. The thermal conductivity of a material determines the amount of heat that can be conducted through that material. Some materials (such as metals) have high thermal conductivity, and other materials (such as rubber or glass) have low thermal conductivity. Common semiconductor packaging materials, such as glass, glass ceramic composites, and plastics, which allow for ease of manufacturing, unfortunately also feature low thermal conductivities which hinder the dissipation of heat.

Depending on the construction of the semiconductor package, a package may have a multitude of various materials of various thermal conductivities through which heat must travel to reach the cooling fluid. This path may be tortuous when many materials with low thermal conductivities are encountered.

Once heat from the semiconductor chip has been conducted through the various materials of the package and reaches the surface of the package it must be convected away to a cooling fluid, such as air.

As noted previously, heat transfer from the external surfaces of semiconductor packages is normally handled by the attachment of specially configured heat sinks which, generally, are mounted over the areas of greatest heat generation. This allows the heat to be conducted from the surface of the package, which usually has a low thermal conductivity, into the heat sink, which preferably has a high thermal conductivity and a large surface area. The heat then is convected away to the ambient air mass. The shapes of the heat sinks are configured to allow for a large surface area which increases heat convection away from the package. In previous applications, where the heat generation of semiconductor chips was moderate, the additional heat transfer capability created by externally bonding the heat sink to the package was sufficient to transfer any heat generated by the chip.

However, as heat generation has increased in the newer semiconductors, the effectiveness of externally mounted heat sinks has decreased. The thermal pathways of the package and heat sink can no longer adequately transfer the heat generated and can subsequently cause malfunctions within the semiconductors.

A major heat transfer problem common to many semiconductor packages is the configuration of the package and the mounting location of the semiconductor chip. Advantageously locating the chip can eliminate several thermal boundaries and improve heat transfer. Because the chip is routinely attached to an internal substrate, the heat generated from the chip must pass through the attachment means to the substrate before it reaches the heat sink mounted on the outer surface of the package. The chip-substrate attachment bonding material adds thermal barriers to the package and limits the maximum heat transfer capability of the package.

Plastic packages introduced decades ago, currently are utilized to package the vast majority of integrated circuits in the semiconductor chip industry. It is estimated that plastic packaging accounts for about 95 percent of the world market in semiconductor chip packaging (or about 40 billion parts per year).

A typical plastic packaging operation involves the following sequence of steps:
1. In order to hold the chip in place, it first is bonded, generally using an epoxy, to a flat surface, commonly referred to as a "paddle", in the center of a lead frame.
2. The chip, held in place on the paddle, then is wire bonded to the lead frame.
3. The lead frame and chip assembly is set within the cavity of a transfer molding fixture and a plastic composition is transferred to fill the cavity, thus encasing the chip, epoxy, paddle, bond wires, and part of the lead frame.
4. The encased assembly is removed from the transfer molding fixture, and the wire leads are trimmed, plated, and formed to specific desired shape.
5. If required for heat dissipation, a heat sink is bonded to the encased assembly.

In standard plastic package assembly, the heat generated by the chip must pass through the epoxy, paddle, and through the plastic encasing the chip, before it reaches the exterior of the plastic. Such an arrangement results in very poor thermal performance, since the epoxy and encasing plastic are poor thermal conductors.

### Summary of the Invention

According to the present invention, an improved plastic chip package has been developed, whereby the non-active back surface of a packaged semiconductor chip is exposed and facing outside of the package. This allows several advantages over conventional packaging: the chip to substrate epoxy attach process is eliminated; with no paddle or epoxy, the chip is situated at one face of the package, allowing ample room for bond wire loops, while still making the package thinner; the chip is exposed for direct attachment of a heat sink; less materials means less mismatched material properties, materials with thermal coefficients of expansion (TCE's) and strength different from silicon are eliminated, thereby improving internal stresses and attendant reliability; and cost savings are realized because less materials means less potential manufacturing problems and fewer assembly steps. Such an arrangement is less expensive, thinner, and accomplishes marked thermal performance improvement over standard arrangements wherein chip-generated heat must be conducted through the plastic package.

The invention in its broad form resides in a molded plastic semiconductor chip package as recited in Claim 1, and a method of forming a molded plastic semiconductor chip package as recited in Claim 13.

As described hereinafter, a molded plastic semiconductor chip package comprises a conventional leadframe member, featuring, however, an opening therein, where typically a paddle mounting platform would have been provided. A semiconductor chip, having an active front side surface and a nonactive back surface, is positioned within said opening, with the nonactive back surface of the chip fully unsupported by said lead frame. Bonding wires extend between the active front side of the chip and bonding pads of the lead frame. A molded plastic body encases the lead frame, bonding wires, and the semiconductor chip, with the nonactive back surface of the chip exposed and facing outside the package. If a heat sink is required, it can be attached in direct contact to the exposed back surface of the chip, for efficient and effective heat dissipation.

The present improved package can be made by a process which features simplified steps in comparison with conventional molded plastic package assembly. Firstly, a semiconductor chip is positioned within an opening of a lead frame. The opening of the lead frame has lateral dimensions greater than those of the chip. During fabrication, the chip initially is held in place in a fixture, preferably by vacuum. The leadframe is held in the same fixture either by vacuum means or other conventional means. While held in the fixture, the chip is wire bonded to the lead frame.
Conventional ball or stitch bonding may be used.

The entire process of bonding the chip to the paddle is eliminated, along with the attendant problems involved with paddle-chip interface.

After wire bonding is accomplished, the chip and lead frame form a partially completed assembly with structural integrity sufficient to withstand normal handling. The assembly may be removed from the wire bonding fixture at this point, with the chip held in free space supported only by the bond wires.

Next, the chip and lead frame assembly is placed into a plastic package mold and held in place as plastic is transferred into the mold, thereby encasing the chip, bond wires, and leads.

To hold the chip and lead frame in place within the mold during the transfer molding process, it is preferred that the back surface of the chip be positioned on a pedestal in the mold. Preferably, the pedestal is equipped with a vacuum port to assist in maintaining the chip in position. When the part is removed from the mold, plastic encases the chip, except the area of the chip back surface which was in contact with, and accordingly shielded by, the support pedestal. This thus leaves the nonactive back surface of the chip exposed and facing outside the package. If a heat sink is required, it readily can be attached directly to the exposed back surface of the chip.

### Brief Description of the Drawings

A more detailed understanding of the invention may be had from the following description of a preferred embodiment, given by way of example and to be understood in conjunction with the accompanying drawing wherein:

Figures 1-3 are cross-sectional views depicting sequential steps in the process for making the molded plastic semiconductor chip package of a preferred embodiment the present invention.

Figure 4 is a cross sectional view of one embodiment of a semiconductor package according to a preferred embodiment the invention.

Figure 5 is a cross sectional view of a fully assembled semiconductor package according to a preferred embodiment the present invention, including an attached heat sink element.

Figures 6-13 are sectional views of additional embodiments of semiconductor packages according to a preferred embodiment the present invention.

### Detailed Description of Preferred Embodiments

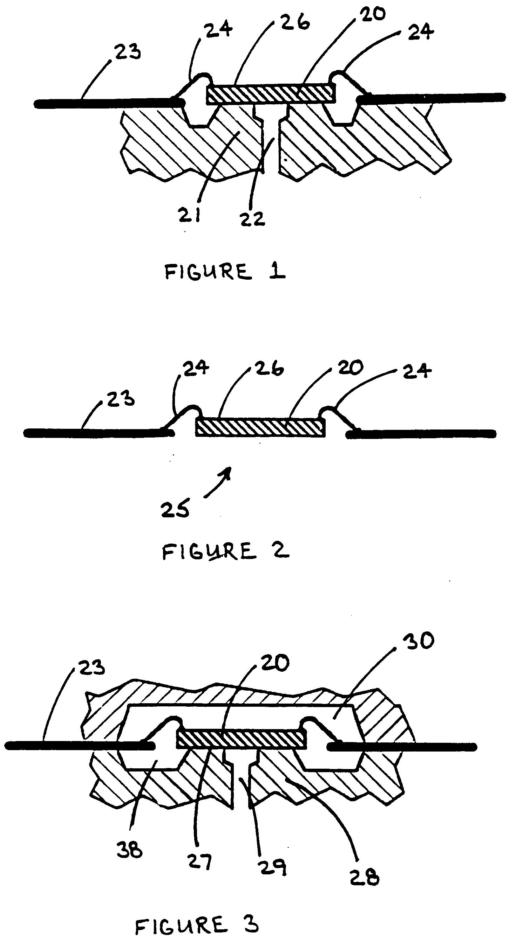

Referring to Figure 1, a semiconductor chip 20 is shown positioned on a fixture pedestal 21, which is equipped with a vacuum port 22 to assist in holding the chip securely in place during the wire bonding operation. While the chip 20 and lead frame 23 are held on the fixture, bondwires 24 are attached between the active side (26) of the chip 20 and the lead frame by an appropriate ball or stitch bonder (not shown). Once the . bondwires are in place, the partially completed assembly 25 (shown in Figure 2) may be removed from the wire bonding fixture. The chip 20, supported only by bondwires 24 has sufficient integrity to allow removal from the bonding fixture and handling of the partially completed assembly, to accommodate transport to the next subsequent process stage. Alternatively, the chip-lead frame assembly may remain in the fixture to travel to the next stage.

As illustrated in Figure 3, the chip 20, wirebonded to lead frame 23, is placed in a mold bottom 38 and the non-active back surface 27 of chip 20 is positioned over mold fixture pedestal 28. The pedestal features vacuum port 29 to assist in holding the chip in place during the molding process. Once the chip and lead frame assembly is set in place in the mold cavity, mold top 30 is assembled onto the mold, and, using conventional transfer molding equipment and techniques, a plastic composition is transferred into the mold and flows around the chip, bondwires, and lead frame as it fills the mold cavity.

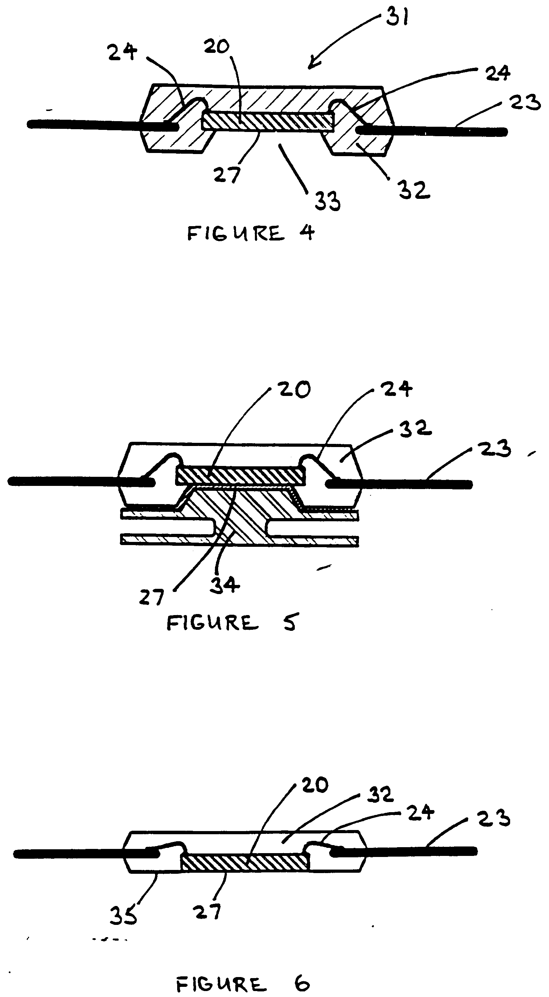

As soon as the plastic sets, the mold top and bottom can be removed and the molded plastic package 31 (Figure 4) can be removed. The plastic package comprises the chip 20, attached by bondwires 24 and lead frame 23, all. encased within plastic molded body 32. The portion of the chip back surface 27 previously positioned on the vacuum mold pedestal remains uncovered by plastic and is exposed and facing outside the package within recess 33.

In Figure 5, a finished molded plastic package is illustrated, including a heat sink 34 fitted into recess 33 in direct thermal contact with the exposed, nonactive back surface 27 of semiconductor chip 20.

Figure 6 shows an embodiment of the invention designed to create a package featuring the back surface 27 of an encased semiconductor chip 20 which is flush with exterior surface 35 of the molded plastic body 32 rather than recessed within. This embodiment offers the advantages of a very thin, lightweight package which can accept a variety of heat sink designs. The leads may exit the mid plane of the plastic, or may be adjusted to accommodate manufacturing steps or applications.

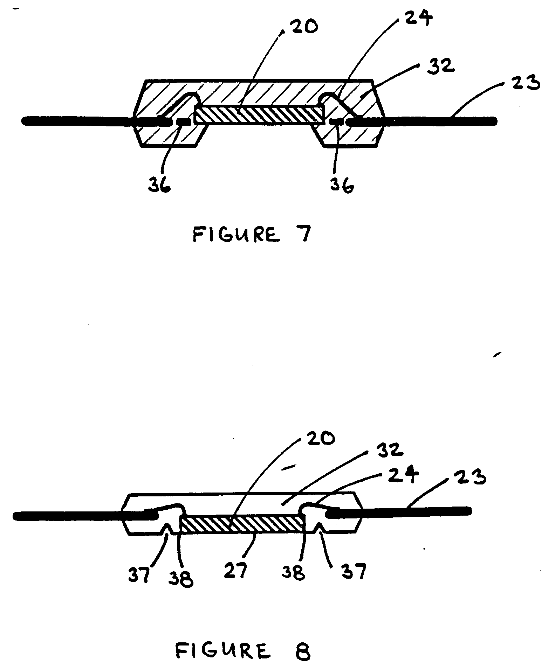

The embodiment of Figure 7 includes a stress reducing ring 36 molded into the plastic material of molded body 32 to reduce stresses and consequent delaminations between the plastic and the chip 20. The ring could be made of any suitable material chosen for its specific mechanical or electrical properties. Typically, the ring may consist of lead frame material. The ring is situated such that it surrounds the outside edges of the chip 20 but is not in contact with it. The ring may be held in place, during the molding operation, by another vacuum port, in which case, a portion of the ring would be exposed. The ring may also be an integral part of the leadframe, i.e., it would be held in place by an adhesive between the leadframe and the ring.

A second embodiment with a different stress-reducing feature is illustrated in Figure 8. At the silicon/plastic/air interface 38, there is a tendency for the plastic to pull away from the silicon, since the plastic in that area is shrinking while it is cooling from the transfer molding temperature, and it shrinks more than the silicon. This difference in thermal contraction creates tension at the silicon/plastic/air interface, often leading to separation. In order to maintain tight contact to seal the joint from the atmosphere, the tension needs to be reduced. Accordingly, a notch 37 is built into the plastic mold body 32 to isolate most of the influence of the plastic body from the joint area. Such a notch readily could be formed, for example, by a positive feature in the mold bottom, and could take on one of various shapes and configurations.

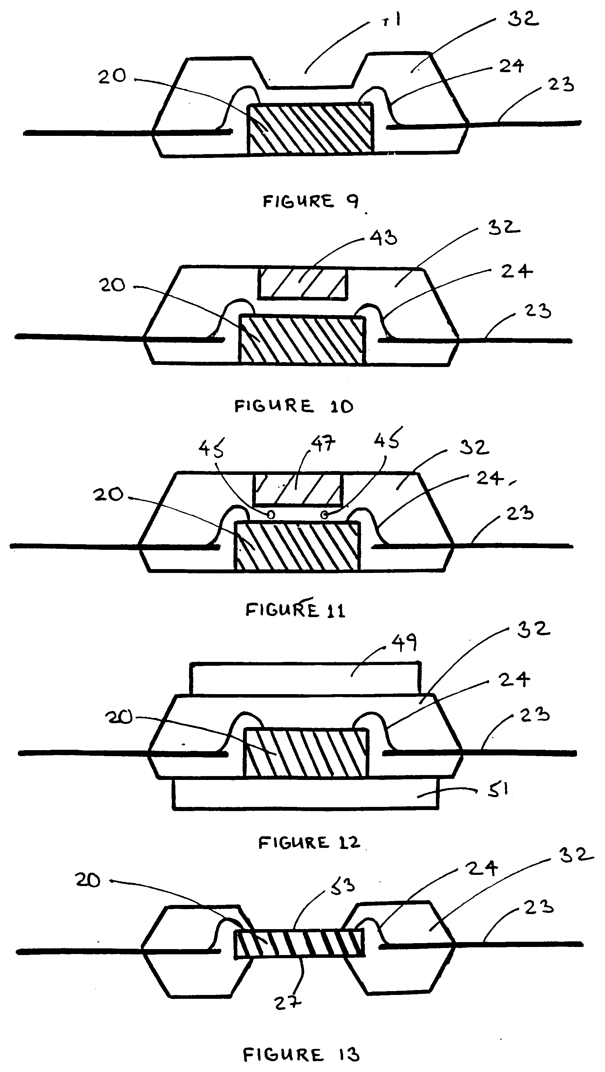

In Figure 9, a relief notch 41 is provided in the top side of the molded plastic body. Such a relief notch serves to reduce package bending caused by the different coefficients of thermal expansion and chip stress. Figure 10 depicts a similar chip package, but featuring a stress relieving insert 43 built into the top side of the molded plastic body. This insert may be made of any suitable material or combination of materials, such as low-expansion silicon, metal, ceramic, and the like. The insert may be positioned by holding it in place during molding with a vacuum port in the top half of the mold. Alternatively, as shown in Figure 11, the insert may be held in place by bumps 45 which may be made of an elastic or plastic material, or other materials. As well as providing stress relief, the insert additionally may serve other functions. For example, insert 47 may be a chip capacitor with bumps 45 forming electrical connections to chip 20, in order to provide power supply stabilization. It may also enhance the thermal cooling of the chip. The insert 43 may take on various thicknesses, lengths or widths, and it may be configured to have perforations or other shapes.

Figure 12 demonstrates another approach to enhance control of deformations caused by thermal coefficient of expansion (TCE), and reduce cracking and moisture ingress. This embodiment includes a cover or foil 49 on the top side of the package, and cover or foil 51 on the bottom side. It could be held in place during molding or added later.

The embodiment illustrated in Figure 13 features a package with both active front side 53 and non-active back surface 27 exposure of chip 20. Such an arrangement might better accommodate electrical connections, testing, enhanced cooling, stress reduction, optical interconnect, and/or an addition wire bonding sequence, and the like.

While the invention has been described with reference to specific embodiments thereof, it is intended that all matter contained in the above description or shown in the accompanying drawings be interpreted as illustrative and not limiting in nature. Various modifications of the disclosed embodiments, as well as other embodiments of the invention, will be apparent to those skilled in the art upon reference to this description, or may be made without departing from the scope of the invention.

## Claims

1. A molded plastic semiconductor chip package including a semiconductor chip, comprising:
a leadframe having an opening therein,
a semiconductor chip having an active front side and a nonactive back surface, with lateral dimensions smaller than those of the lead frame opening, positioned within said opening with the nonactive back surface of the chip fully unsupported by said lead frame,
bonding-wires extending between the active front side of the chip and bonding pads carried by the lead frame, and
a molded plastic body encasing said lead frame and said semiconductor chip with the nonactive back surface of said chip exposed and facing outside the package.

2. The semiconductor package of Claim 1 wherein the back surface of the semiconductor chip is flush with the back surface of the molded plastic body.

3. The semiconductor package of Claim 1 including a heat sink attached to said package in intimate contact with the exposed backside of said semiconductor chip.

4. The semiconductor package of Claim 1 wherein the molded plastic body includes a stress relief feature.

5. The semiconductor package of Claim 4 wherein said stress relief feature is a ring of lead frame material.

6. The semiconductor package of Claim 4 wherein the stress relief feature is a notch in the back surface of the plastic body.

7. The semiconductor package of Claim 4 wherein the stress relief feature is a relief notch in the top side of the plastic body.

8. The semiconductor package of Claim 4 wherein the stress relief feature is an insert in the top side of the plastic body.

9. The semiconductor package of Claim 8 wherein said insert is selected from silicon, metal, and ceramic.

10. The semiconductor package of Claim 8 wherein said insert is a capacitor electrically connected to the semiconductor chip.

11. The semiconductor package of Claim 4 wherein said stress relief feature comprises a cover bonded to at least one side of the package.

12. The semiconductor package of Claim 4 wherein said stress relief feature comprises relief notches in both the top side and back surface of the plastic body, so as to expose both the active front side and non-active back surface of the semiconductor chip.

13. A method of forming a molded plastic semiconductor chip package comprising:
positioning a semiconductor chip, having an active front side and a nonactive back surface, within an opening of a lead frame, said opening having lateral dimensions greater than those of the chip,
attaching bonding wires between the active front side of the chip and bonding pads carried by the lead frame,
holding said chip and said lead frame within a package mold by supporting the back surface of said chip, and
forming a plastic body within said mold to encase said chip and said lead frame while leaving a substantial portion of the back surface of said chip exposed and facing outside the package.

14. The method of Claim 13 wherein the semiconductor chip is positioned within an opening of a lead frame by mounting said chip on a vacuum pedestal.

15. The method of Claim 13 wherein the backside of said chip is held within a package mold by supporting said chip on a vacuum pedestal.
